# EUROPEAN PATENT SPECIFICATION

(11) **EP 0 556 185 B1**
(45) Date of publication and mention of the grant of the patent: **15.01.1997**
(21) Application number: 91914883.3
(22) Date of filing: 27.08.1991
(51) Int. Cl.: A01G 23/08

(54) **SYSTEM FOR CONTROLLING THE CLAMP MEANS IN A TREE HARVESTING MACHINE, ESPECIALLY GRAPPLE HARVESTER**
SYSTEM ZUM STEUERN DER SPANNMITTEL IN EINER BAUMERNTEVORRICHTUNG, INSBESONDERE EINE VORRICHTUNG MIT GREIFERN
SYSTEME DE COMMANDE DE LA TENAILLE D'UNE MACHINE DE RECOLTE DE BOIS, NOTAMMENT UNE MACHINE A PINCE

(30) Priority: 27.08.1990 FI 904213
(43) Date of publication of application: 25.08.1993
(73) Proprietor: PLUSTECH OY, 33101 Tampere (FI)
(72) Inventor: TIMPERI, Arto, SF-33700 Tampere (FI); PAAKKUNAINEN, Marko, SF-33720 Tampere (FI)
(74) Representative: Diehl, Hermann O. Th., Dr.
(86) International application number: FI9100264
(87) International publication number: WO9203040

(56) References cited:
- DE-A- 3 112 573
- FI-B- 58 576
- SE-B- 399 000
- SE-B- 451 937
- SE-B- 453 005
- SE-B- 454 129
- SE-B- 464 678

## Description

The invention relates to a system for controlling the clamp means in a tree harvesting machine, especially grapple harvester, the system being of the type described in the preamble portion of the appended claim 1.

In US-Patent 4.546.805 is disclosed a system comprising means controlling the flow of pressure medium to actuators which are connected to the clamp means in a power transmitting way, said control means being placed on a line for pressure medium. The system comprises further a relief valve. The defect in this type of system is that it can not be used in such tree harvesting machines comprising other actuators consuming the output power of pressure medium, especially tree feeding devices. In this case problems arise which are concerned with the adjustment of the clamping pressure to a desired level, its preservation, and the elimination of pressure shocks during the feed.

In the publication DE-A-3112573 is known a hydraulic system for feeding pressure medium to actuators moving the delimbing knives and feed rollers in a tree processing machine. A pressure-reducing valve is situated on the pressure medium line before a directional control valve. In this solution all factors associated with tree processing, such as differing pressure needs and avoiding of shocks, are not taken into account.

Further, a control system for the clamp means in a grapple harvester is known where for adjusting the clamping pressure, a pressure-reducing valve is placed on the line for pressure medium and it is designed for permitting the flow of pressure medium at a predetermined pressure to the actuator, and further a relief valve and a directional control valve are provided on the line after the pressure-reducing valve. The pressure-reducing valve and the means connected to the pressure medium line after it are placed in a part carrying the clamp means, such as in a felling head. In this solution the directional control valve is situated between the relief valve and the actuator, and the valves have a fixed point of action, which can be changed only by means of a tool.

The object of the invention is to eliminate the above-mentioned drawbacks and disclose a system which is well suitable especially for a grapple harvester. The term grapple harvester denotes a tree harvesting machine comprising clamp means taking hold of a tree, feeding means for feeding the tree between the clamp means as well as a cross-cutting saw for cutting the tree to desired lengths. The grapple harvester is preferably provided also for performing the cutting of the tree for felling. For reaching this goal the invention is mainly characterized by what is disclosed in the characterizing portion of the appended claim 1. By means of the arrangement and control of the valves, on one hand too high a pressure can be prevented from entering the clamp means and the pressure can be adjusted to a desired level therein, and on the other hand by means of the pressure relief valve placed after the directional control valve pressure shocks caused by irregularities of a tree during the feed can be avoided.

The pressure reducing valve and also the relief valve are connected to a common pilot valve which determines the pressure level and by means of which their operating point can be chosen to a desired value. For ensuring the preservation of the clamp during the feed, the line of pressure medium is connected to a pressure accumulator, according to one advantageous embodiment, and this line branches off to the pressure accumulator preferably before a directional control valve that controls the direction of movement of the actuators. For improving the occupational safety the line to the pressure accumulator can further incorporate a directional control valve that is designed for unloading the pressure accumulator after the work. All aforementioned means can be installed in a part that supports the clamp means, such as in a felling head, and all valves present therein can be integrated to a single valve block.

The invention will be described in the following more closely by reference to the accompanying drawings, wherein
- Fig. 1: shows the system according to the invention in a schematical view, and
- Fig. 2: shows one alternative system for the pilot control valves in a schematical view.

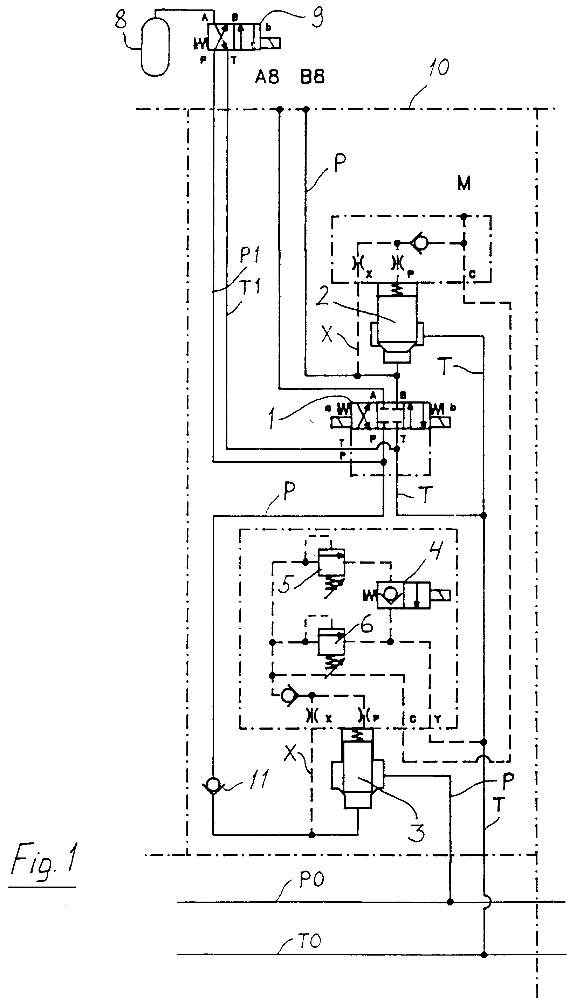

Fig. 1 shows the system according to the invention as a hydraulic scheme. The means shown in the scheme are installed in a part that supports the clamp means in a tree harvesting machine, such as in a felling head in the same valve block, which is surrounded by broken line 10. A line P for pressure medium branches off from a main line P0 situated in the felling head and coming from a pump. Correspondingly, a line T comes from the valve block to enter a main line T0 going to a tank. The pair of main lines P0, T0 concerned is also connected to means for rotating the feed motors, means for rotating the saw, as well as to other means situated in the felling head, such as to means for felling and lifting and to blade opening means. All the above-mentioned means get their power from the pressure medium lines branching off from the main line P0 of the felling head and they are controlled with control means which are not described more closely herein.

In the pressure medium line P branching off into the valve block 10 there is, as seen in the flow direction of the pressure medium first a pressure-reducing valve 3 which is designed to allow pressure medium at a predetermined pressure to flow to an actuator effecting the pressing of the clamp means, said actuator being denoted by port B8. To the port B8 are connected in parallel those work chambers of the hydraulic cylinders in the felling head which under the pressure passed thereto accomplish the closing of the clamp means and the pressing around the tree. The operation of the pressure reducing valve 3 will be described more closely hereinafter. After the valve on the line theme is a check valve 11 which ensures for its part the preservation of the clamping pressure in the line P. After the check valve on the line there is a branching point, at which a line P1 branches off to a pressure accumulator 8. After the branching point there is a 4/3 directional control valve 1, by means of which the direction of action of the clamp means can be chosen with the aid of electric control. The valve is provided for closing the feed of pressure medium along the line P by spring action in the rest position. After the directional control valve 1 the line P branches off to a relief valve 2, which is designed to allow the pressure medium at a predetermined pressure to flow to the line T passing to the tank. After said point the pressure medium line P passes through the port B8 connected in the above-mentioned manner to the actuators and the line passes further to the actuators, which are in a power transmitting relationship to the clamp means.

Clamping means are understood in this context to mean means carrying the tree feeding means, such as feeding rollers, said clamping means clamping the tree there-between at the feeding means so that they will be able to feed the tree forward. The clamping means can also be lopping blades and the system according to the invention can also be used for controlling their clamping action. The means carrying the feeding means and the lopping blades can each be controlled by their respective system, but the lopping blades can be connected mechanically to the means carrying the feeding means, in which event both are controlled by a common system.

The above description has made reference to the flow of the pressure medium in a situation where the directional control valve 1 is at its right position, where the line connected to the port B8 after the directional control valve is under pressure and the line coming from the exhaust side of the actuators through the port A8 is connected to the line T passing into the tank.

The pressure reducing valve 3 is a cartridge valve which is designed to limit the pressure prevailing in the line P that follows it under a certain level. The construction of the valve is not discussed in more detail in this context, because also other valves performing this type of action can be considered here. However, it can be stated briefly that the valve is a normal valve urged by a spring in an open position so that the bores in its poppet are free to permit the flow of the pressure medium into the line P situated after the valve 3. As the poppet is displaced, influenced by the pressure prevailing in said line, the holes will close simultaneously and the pressure within the line after the valve 3 adjusts itself automatically to be below a predetermined point of action. The valve is connected to a pilot valve through a pilot line X that branches off from the line situated after the valve. The pilot valve is constituted of relief valves 5 and 6 coupled in parallel to the pilot line X and of a valve 4 coupled in series with one (5) of the valves and being closed at its rest position. When the pressure increases in the line P situated after the valve 3 above a certain value determined by the valves 5 and 6 the pressure prevailing in the pilot line X can be discharged through one of the pilot valves to the tank line T, and the pilot pressure connected to the pilot line X and prevailing on the other side of the poppet that keeps the valve 3 open is also discharged and the valve will be closed. The point of action of the valve 3 is determined according to the pilot valves 5 and 6 coupled in parallel, and they are designed to act at different pressures. The choice can be made with the help of the valve 4. When the valve 4 is in the closed position shown by Fig. 1, the point of action is determined according to the valve 6 operative at the higher pressure, and when the valve 4 is open, the connection from the pilot line to the tank line T will be opened through the valve 4 operative at the lower pressure and determining the point of action in this case. The valve 4 can be controlled electrically and its position for each working phase can be for example programmed in advance in the program controlling the work cycle.

The relief valve 2 situated after the directional control valve 1 is also connected to the same pilot valves 5, 6 through a pilot line X which is connected to the pressure medium line P situated after the directional control valve 1. When the pressure increases in the line P after the directional control valve 1, this pressure will be mediated in the above-described manner through the pilot line X to the parallelly coupled assembly of the pilot valves 5 and 6, and when the pressure increases in the line P above the level determined by the pilot valve 5 or 6, the valve 2 will open as the space situated on the other side of the poppet and connected to the pilot line X is deprived of the pilot pressure tending to close the poppet, thus allowing the passage of the pressure into the tank line T. By the action of the relief valve 2, the pressure rise owing to external factors affecting the position of the clamp means, such as pressure shocks caused by the irregularities of the tree to be fed, can be avoided in the line P.

For ensuring a smooth co-operation of the valves 3 and 2 the point of action of the valve 2 is designed to be at a higher pressure than that of the valve 3. In the practice this can be achieved by making the spring of the valve 2 stiffer than that of the valve 3.

The above-described pressure adjustment functions are remarkable for the system shown by Fig. 1 in the sense that within the block 10 the line P under pressure extending from the valve 3 up to the port P8 is accomplished solely by means of bores, and consequently it has no hoses with flexible walls capable of smoothening pressure shocks. The modular technique, however, allows to accomplish a compact structure, the centralization of all operative parts to one single assembly, small volumes of liquid as well as good dynamics, that is, quick action.

The system comprises also a pressure accumulator port. As mentioned above, the pressure line P1 for charging the pressure accumulator branches off from the line P after the check valve 11 before the directional control valve 1. The location of the point before the directional control valve ensures that the accumulator will be charged also when the directional control valve is closed. The line P1 passes to the pressure accumulator 8 through a directional control valve 9, which in its spring-loaded rest position connects the pressure accumulator 8 to a return line T1, which is connected to the tank line T0 for discharging the pressure of the pressure accumulator. Said operation ensures that the pressure accumulator will be discharged when the felling head is not operated. During the work cycle the valve 9 is electrically shifted to the work position wherein the line P1 gets in communication with the pressure accumulator 8 and the pressure accumulator can be charged and it can perform its general function of smoothening the pressure. In course of pressure decrease within the line P for example during the decrease in the diameter of the tree to be fed in its longitudinal direction, the line P1 that is open up to the pressure accumulator quarantees the maintenance of a certain clamp in the clamp means. The pressure can decrease in the line P also owing to the fact that as the tree is fed the feeding motors connected to the main line P0 consume some power. When the work machine is switched off the valve 9 will automatically return to the position where the pressure accumulator is discharged.

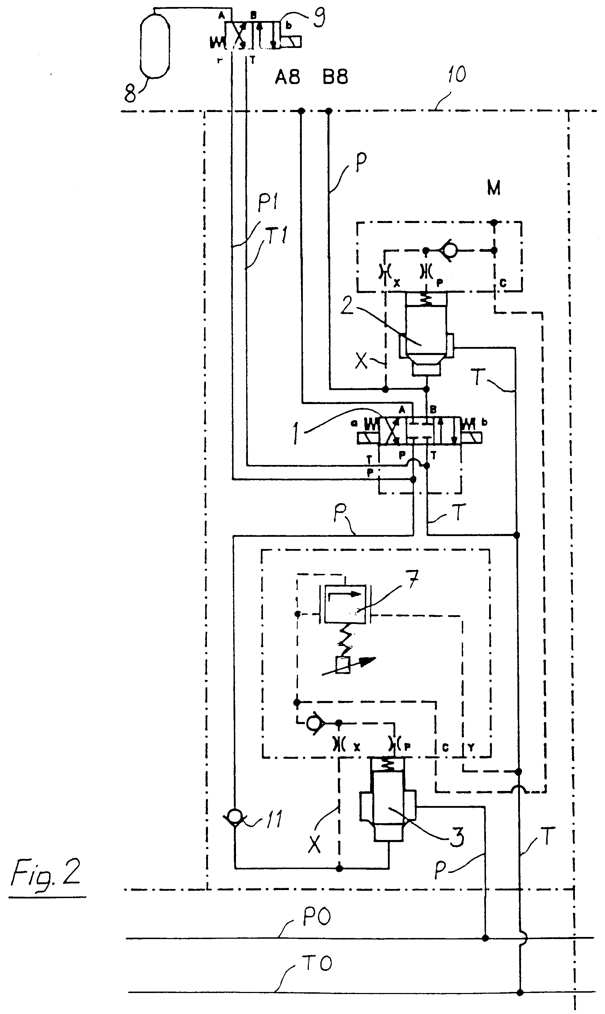

Fig. 2 shows one alternative system regarding pilot valves. Like in Fig. 1, also this alternative provides for the connection of both the valve 3 and the valve 2 to the same pilot valve, each through its own pilot line X. However, the valves 5 and 6 coupled in parallel and the valve 4 for choosing between them are replaced with a proportional valve 7. The pressure of action of this type of relief valve can be adjusted steplessly outside the valve electronically, for example from a driving cabin or by means of program controlling the work cycle and setting the desired pressures during the work cycle.

With the aid of the combination of the pilot valves 5 and 6 or the proportional valve 7, different pressures can be chosen for the clamp means. When the clamp means engage the tree for a cut for the felling, the point of action of the valve 3 can be set to a higher pressure, that is, the clamping force will thus be greater, and when the tree is fed between the clamp means, the point of action can be at a lower pressure. A suitable clamping pressure on engaging a standing tree can be for example 190 bar and the corresponding pressure during the feed can be for example 130 bar. The choice is made by means of the valve 4 of Fig. 1 or by adjusting correspondingly the proportional valve 7 of Fig. 2.

The invention is not restricted hereinabove only to the embodiment shown by the drawings, but it can be modified within the scope of the invention represented by the claims. The functions of the system can be accomplished also by using analogous parts. Because a compact structure is required in the felling heads suspended from boom ends of tree harvesting machines, it is preferred that the means that control common means, such as actuators operating the clamp means, are incorporated to the same valve block. In this case it is profitable to integrate the pressure-reducing valve 3, the pilot valves 5, 6 or 7, the directional control valve 1 and the relief valve 2 to the same valve block. It is also profitable to integrate the directional control valve 9 for the pressure accumulator into this same block. The fluid volume of the system will consequently remain small. The valves 3 and 2 are preferably accomplished using cartridge technique.

In the system the functions effecting the speed (modular technique) and the functions effecting the elasticity (the valves 3 and 2 and the pressure accumulator 8) are separated from each other, the fact which improves the controllability of the system.

## Claims

1. System for controlling the clamp means in a tree harvesting machine, especially grapple harvester, the system comprising means controlling the flow of pressure medium to actuators (B8) which are connected to the clamp means in a power transmitting way, said control means being placed in a line (P) for pressure medium, whereby for adjusting the clamping pressure, a pressure reducing valve (3) is placed in the line (P) for pressure medium and it is designed for permitting the flow of pressure medium at a predetermined pressure to the actuators (B8), a relief valve (2) and a directional control valve (1) being further provided in the line (P) for pressure medium after the pressure-reducing valve (3), whereby the pressure-reducing valve (3) and the means situated after it and being connected to the line (P) for pressure medium are placed in a part carrying the clamp means, such as in a felling head, **characterized** in that the relief valve (2) is situated in the line (P) for pressure medium after the directional control valve (1) and that the pressure-reducing valve (3) and the relief valve (2) are connected to a common pilot valve (5, 6; 7) determining the pressure level and being controllable electrically for choosing at least two different points of action for the pressure-reducing valve (3) and the relief valve (2).

2. System as claimed in claim 1, **characterized** in that the point of action of the relief valve (2) is set at a higher pressure than that of the pressure-reducing valve (3).

3. System as claimed in claims 1 or 2, **characterized** in that the line (P) for pressure medium branches off as a line (P1) passing to a pressure accumulator (8).

4. System as claimed in claim 3, **characterized** in that the line (P) branches off to the pressure accumulator (8) before a directional control valve (1) controlling the direction of movement of the actuators.

5. System as claimed in claim 3 or 4, **characterized** in that on the line (P1) passing to the pressure accumulator (8) after the branching point there is a directional control valve (9), which in its rest position is provided for connection between the pressure accumulator (8) and a line (T1, T) passing to a tank and its working position provided for connection between the pressure accumulator and the line (P) for pressure medium.

6. System as claimed in claim 1, **characterized** in that the pressure-reducing valve (3), the pilot valves (5, 6; 7), the directional control valve (1) and the relief valve (2) are integrated to one single valve block.

## Patentansprüche

1. System zur Steuerung der Klemmittel in einem Harvester, insbesondere einem Greifharvester, wobei das System Mittel zur Steuerung des Flusses von Druckmedium zu Stellgliedern (B8) aufweist, welche in kraftübertragender Weise mit den Klemmitteln verbunden sind, wobei die Steuermittel in einer Leitung (P) für Druckmedium positioniert sind, wobei zum Einstellen des Klemmdrucks ein Druckreduzierungsventil (3) in der Leitung (P) für Druckmedium positioniert ist und darauf ausgerichtet ist, den Fluß von Druckmedium bei vorbestimmtem Druck zu den Stellgliedern (B8) zu gestatten, wobei ein Entlastungsventil (2) und ein Richtungssteuerventil (1) des weiteren auf der Leitung (P) für Druckmedium nach dem Druckreduzierungsventil (3) zur Verfügung gestellt sind, wobei das Druckreduzierungsventil (3) und die nach diesem angeordneten und mit der Leitung (P) für Druckmedium verbundenen Mittel in einem Teil positioniert sind, welcher die Klemmittel trägt, wie beispielsweise in einem Fällkopf, dadurch gekennzeichnet, daß das Entlastungsventil (2) in der Leitung (P) für Druckmedium nach dem Richtungssteuerventil (1) angeordnet ist, und daß das Druckreduzierungsventil (3) und das Entlastungsventil (2) mit einem gemeinsamen Schaltventil (5, 6; 7) verbunden sind, welches das Druckniveau bestimmt und elektrisch steuerbar ist, um mindestens zwei unterschiedliche Aktionspunkte für das Druckreduzierungsventil (3) und das Entlastungsventil (2) zu wählen.

2. System gemäß Anspruch 1, dadurch gekennzeichnet, daß der Aktionspunkt des Entlastungsventils (2) bei einem höheren Druck als jener des Druckreduzierungsventils (3) eingestellt ist.

3. System gemäß Anspruch 1 oder 2, dadurch gekennzeichnet, daß die Leitung (P) für Druckmedium als Leitung (P1) abzweigt, welche zu einem Drucksammler (8) führt.

4. System gemäß Anspruch 3, dadurch gekennzeichnet, daß die Leitung (P) zu dem Drucksammler (8) vor einem Richtungssteuerventil (1) zur Steuerung der Bewegungsrichtung der Stellglieder abzweigt.

5. System gemäß Anspruch 3 oder 4, dadurch gekennzeichnet, daß sich auf der nach dem Abzweigepunkt zu dem Drucksammler (8) führenden Leitung (P1) ein Richtungssteuerventil (9) befindet, welches in Ruheposition zur Verbindung zwischen dem Drucksammler (8) und einer Leitung (T1, T), welche zu einem Tank führt, zur Verfügung gestellt und in Betriebsposition zur Verbindung zwischen dem Drucksammler und der Leitung (P) für Druckmedium zur Verfügung gestellt ist.

6. System gemäß Anspruch 1, dadurch gekennzeichnet, daß das Druckreduzierungsventil (3), die Schaltventile (5, 6; 7), das Richtungssteuerventil (1) und das Entlastungsventil (2) zu einem einzigen Ventilblock integriert sind.

## Revendications

1. Système de commande des moyens de blocage d'une abatteuse-élagueuse d'arbres, en particulier une abatteuse-élagueuse à grappin, le système comprenant des moyens pour commander l'écoulement d'un milieu sous pression vers des moyens d'actionnement (B8) qui sont connectés aux moyens de blocage suivant une relation de transmission d'énergie, lesdits moyens de commande étant placés dans une conduite (P) du milieu sous pression, système dans lequel, pour ajuster la pression de blocage, une soupape réductrice de pression (3) est placée dans la conduite (P) du milieu sous pression et est conçue pour permettre l'écoulement du milieu sous pression, à une pression prédéterminée, vers les moyens d'actionnement (B8), un détendeur (2) et une soupape de commande directionnelle (1) étant en outre prévus dans la conduite (P) du milieu sous pression, au-delà de la soupape réductrice de pression (3), de sorte que la soupape réductrice de pression (3) et les moyens situés au-delà de celle-ci et connectés à la conduite (P) du milieu sous pression sont placés dans une partie supportant les moyens de blocage, pur exemple dans une tête d'abattage, système caractérisé en ce que le détendeur (2) est situé, dans la conduite (P) du milieu sous pression, au-delà de la soupape de commande directionnelle (1) et en ce que la soupape réductrice de pression (3) et le détendeur (2) sont connectés à une soupape pilote commune (5, 6 ; 7) déterminant le niveau de pression et qui peut être commandée électriquement pour choisir au moins deux points de fonctionnement différents pour la soupape réductrice de pression (3) et le détendeur (2).

2. Système selon la revendication 1, caractérisé en ce que le point de fonctionnement du détendeur (2) est réglé à une pression plus élevée que celui de la soupape réductrice de pression (3).

3. Système selon la revendication 1 au 2, caractérisé en ce que la conduite (P) du milieu sous pression se ramifie pour donner naissance à une conduite (P1) aboutissant dans un accumulateur de pression (8).

4. Système selon la revendication 3, caractérisé en ce que la conduite (P) se ramifie vers l'accumulateur de pression (8) en amont de la soupape de commande directionnelle (1) commandant la direction de déplacement des moyens d'actionnement.

5. Système selon la revendication 3 ou 4, caractérisé en ce qu'une soupape de commande directionnelle (9) se trouve sur la conduite (P1) débouchant dans l'accumulateur de pression (8) au-delà du point de ramification, laquelle soupape est prévue, dans sa position de repos, pour réaliser la connexion entre l'accumulateur de pression (8) et une conduite (T1, T) débouchant dans un réservoir et, dans sa position active, pour réaliser la connexion entre l'accumulateur de pression et la conduite (P) de milieu sous pression.

6. Système selon la revendication 1, caractérisé en ce que la soupape réductrice de pression (3), la soupape pilote (5, 6 ; 7), la soupape de commande directionnelle (1) et le détendeur (2) sont intégrés à un ensemble de soupapes unique.
